# FASCICULE DE BREVET EUROPEEN

(11) **EP 3 175 469 B1**
(45) Date de publication et mention de la délivrance du brevet: **29.08.2018**
(21) Numéro de dépôt: 15742269.2
(22) Date de dépôt: 27.07.2015
(51) Int. Cl.: H01H 39/00, H03K 3/57

(54) **GÉNÉRATEUR D'IMPULSION ÉLECTRIQUE**
ELEKTRISCHER PULSGENERATOR
ELECTRIC PULSE GENERATOR

(30) Priorité: 28.07.2014 FR 1457280
(43) Date de publication de la demande: 07.06.2017
(73) Titulaire: Commissariat à l'Énergie Atomique et aux Énergies Alternatives, 75015 Paris (FR)
(72) Inventeur: MONJAUX, Philippe, F-33470 Gujan-Mestras (FR)
(74) Mandataire: Brevalex
(86) Numéro de dépôt international: PCT/EP2015/067171
(87) Numéro de publication internationale: WO 2016/016195

(56) Documents cités:
- EP-A1- 0 158 482
- DE-B1- 2 412 261
- DE-C1- 4 438 157
- DE-U1- 29 700 594
- US-A- 3 238 321
- US-A- 5 252 796
- US-A1- 2013 150 935

## Description

### DOMAINE TECHNIQUE

La présente invention concerne un générateur d'impulsion électrique. Un tel générateur d'impulsion électrique peut être utilisé dans tous domaines nécessitant des décharges électriques rapides de haute tension comme des dispositifs de mise de feu, des générateurs de hautes puissances pulsées tels les générateurs de Marx, ou les générateurs à addition inductive de tension ou générateurs IVA (pour inductive voltage adder), ou des dispositifs de protection permettant de court-circuiter une source d'énergie.

### ÉTAT DE LA TECHNIQUE ANTÉRIEURE

Des commutations rapides à haute tension peuvent être obtenues par un élément de commutation à décharge électrique de type éclateur à gaz ou sous vide. La conception de ces éclateurs est délicate car ils doivent tenir en statique la tension de charge des condensateurs dont ils doivent déclencher la décharge et être très peu inductifs pour pouvoir réaliser des décharges très rapides. Des éclateurs multicanaux sont préconisés. Un autre de leurs inconvénients est qu'ils sont volumineux. Ils comportent plusieurs groupes d'électrodes. En outre, ils nécessitent généralement des systèmes de déclenchement complexes pour synchroniser les décharges dans les différents groupes d'électrodes.

Sur certains générateurs de hautes puissances pulsées, au lieu d'utiliser un élément de commutation à décharge électrique, on trouve des dispositifs pyrotechniques à base d'explosifs qui permettent lorsqu'ils sont mis à feu de fermer un contact électrique. L'effet recherché est la projection rapide de matière par un explosif, ce qui engendre la destruction d'une zone isolante et la fermeture du contact électrique. Un inconvénient est qu'il est difficile de gérer la destruction de la zone isolante avec projection de matière.

Des composants semi-conducteurs de puissance peuvent aussi être utilisés comme commutateurs de forte puissance. Leur inconvénient est qu'ils ne peuvent fonctionner dans certains environnements radiatifs et sont limités en tension et/ou courant de décharge. Le document US 5 252 796 A décrit un tel générateur.

### EXPOSÉ DE L'INVENTION

La présente invention a justement comme but de proposer un générateur d'impulsion électrique qui est simple, léger et robuste.

Un autre but de l'invention est de proposer un générateur d'impulsion électrique dont le coût est très faible.

Encore un autre but de l'invention est de proposer un générateur d'impulsion électrique qui peut être intégré facilement dans un circuit électrique car il est monobloc et compact.

Un but supplémentaire de l'invention est de proposer un générateur d'impulsion électrique qui est particulièrement fiable, car il n'est pas sujet à l'auto-amorçage.

Encore un but supplémentaire de l'invention est de proposer un générateur d'impulsion électrique qui n'a pas besoin de fonctions périphériques pour sa commutation, tels que des déclencheurs à haute tension volumineux et coûteux.

Un but additionnel de l'invention est de proposer un générateur d'impulsion électrique qui est opérationnel dans des environnements sévères, radiatifs naturels ou artificiels, c'est-à-dire en présence de neutrons, protons, ions lourds, rayons X, rayons gamma, ou bien sous vide.

Pour parvenir à ces buts, la présente invention propose un générateur d'impulsion électrique comportant un commutateur à décharge électrique et un dispositif de stockage d'énergie associé avec la ou chaque paire d'électrodes du commutateur à décharge électrique en au moins un montage en série, le générateur étant destiné à alimenter au moins une charge, la charge ou chaque charge étant destinée à être montée en parallèle avec le ou chaque montage en série. Le commutateur à décharge électrique comporte au moins un piston et une chambre dans laquelle le ou chaque piston est apte à se déplacer, un déclencheur générateur de gaz propulseur pour mettre en mouvement le ou chaque piston, situé à proximité d'une extrémité du ou de chaque piston, au moins un poinçon solidaire de l'autre extrémité du ou de chaque piston, au moins un empilement de couches, formé d'au moins une paire d'électrodes séparées par une couche de matériau diélectrique, le ou chaque empilement étant situé du côté d'un ou de plusieurs des poinçons, le ou chaque poinçon étant destiné à coopérer avec au moins une paire d'électrodes, les électrodes de ladite paire étant destinées à être portées à des potentiels différents avant la mise en mouvement du piston portant le poinçon destiné à coopérer avec ladite paire d'électrodes, de manière à ce que lorsque ledit piston est mis en vitesse par le gaz généré par le déclencheur, le poinçon poinçonne la couche de matériau diélectrique séparant les électrodes de ladite paire, entraînant le claquage du matériau diélectrique et la survenue d'une décharge électrique entre les électrodes de ladite paire.

Pour obtenir plusieurs décharges électriques espacées dans le temps, le ou chaque empilement de couches peut comporter plusieurs paires d'électrodes empilées, séparées chacune par une couche de matériau diélectrique, deux paires voisines étant séparées par un espaceur électriquement isolant. Ainsi en poinçonnant les couches de matériau diélectrique séparant plusieurs paires d'électrodes empilées, le poinçon entraîne la génération de plusieurs décharges électriques séparées dans le temps.

L'épaisseur de l'espaceur entre deux paires d'électrodes voisines conditionne l'intervalle de temps entre deux décharges électriques successives.

Au moins un piston peut être équipé de plusieurs poinçons, un même empilement comportant au moins autant de paires d'électrodes que le nombre de poinçons dudit piston, ces paires d'électrodes étant séparées par une couche de matériau diélectrique, les électrodes de paires différentes étant sans contact électrique direct. Les poinçons dudit piston, en poinçonnant chacun la couche de matériau diélectrique séparant deux électrodes d'une paire d'électrodes déclenchent des décharges électriques sensiblement simultanées.

Dans un souci de simplification, la couche de matériau diélectrique peut être commune à plusieurs paires d'électrodes.

Le commutateur à décharge électrique du générateur de décharge électrique objet de l'invention peut comporter plusieurs pistons, chacun équipé d'au moins un poinçon, et un empilement de couches dédié à chacun des pistons, chaque empilement de couches comportant au moins une paire d'électrodes par poinçon du piston dédié, ces électrodes étant séparées par une couche de matériau diélectrique. Ainsi, les poinçons en perforant chacun une couche en matériau diélectrique peuvent déclencher des décharges électriques sensiblement simultanées ou successives.

Le déclencheur de gaz propulseur est avantageusement une cartouche pyrotechnique génératrice de gaz.

Le ou chaque poinçon est avantageusement réalisé en matériau électriquement isolant, de préférence choisi parmi le polyéthylène, le polypropylène, le polychlorure de vinyle, la céramique, une résine ou dans un matériau électriquement conducteur, de préférence en acier.

Le matériau diélectrique de la couche est de préférence choisi parmi le polyéthylène, les polyimides, le kapton (marque déposée de Du Pont de Nemours).

L'espaceur peut être réalisé dans un matériau électriquement isolant ou dans un matériau électriquement conducteur. L'espaceur en matériau électriquement conducteur est muni d'au moins un orifice dimensionné de manière à pouvoir être traversé par un poinçon, et à être sans contact électrique avec le poinçon qui le traverse, lorsque le poinçon est en matériau électriquement conducteur.

Les électrodes de la paire ou de chaque paire peuvent être réalisées dans un matériau électriquement conducteur, de préférence choisi parmi l'aluminium, le cuivre, leurs alliages.

L'épaisseur de la couche de matériau diélectrique séparant la ou chaque paire d'électrodes est choisie en fonction de la capacité de stockage du dispositif de stockage d'énergie associé avec la ou chaque paire d'électrodes afin que la décharge électrique générée par le commutateur à décharge électrique soit apte à faire se décharger le dispositif de stockage d'énergie.

Le dispositif de stockage d'énergie est une source de tension, de préférence, choisie parmi un condensateur, un banc de condensateurs, un super-condensateur.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
Les figures 1A, 1B sont des coupes du commutateur à décharge électrique (tel que présent dans le générateur à impulsion électrique objet de l'invention) en position de repos et en fonctionnement lors du mouvement de son piston, la figure 1C montre le piston en position finale le poinçon ayant perforé l'empilement ; la figure 1D montre un mode de réalisation dans lequel l'empilement comporte un espaceur muni d'un orifice et deux paires d'électrodes empilées ;
La figure 2 donne l'allure du courant de décharge circulant entre les deux électrodes d'une paire d'électrodes du commutateur à décharge électrique de l'invention en fonction du temps ;
Les figures 3A à 3E sont des représentations schématiques de différentes variantes d'un générateur d'impulsion électrique objet de l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

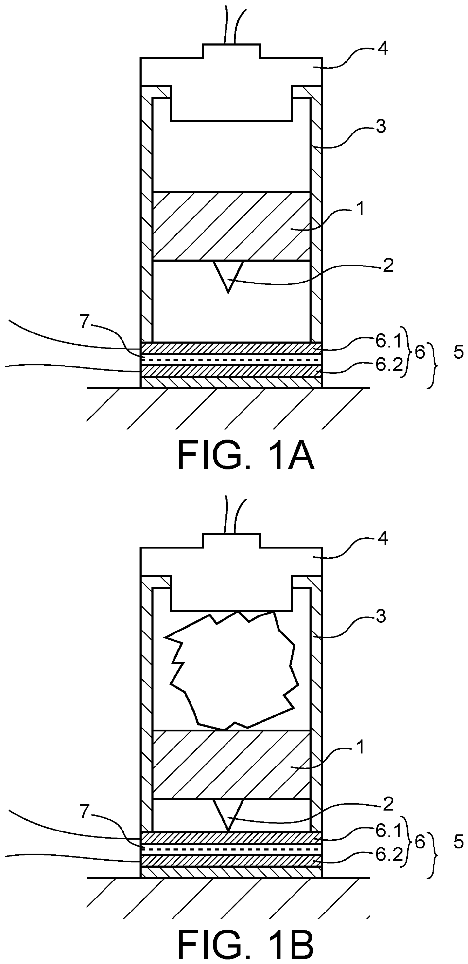

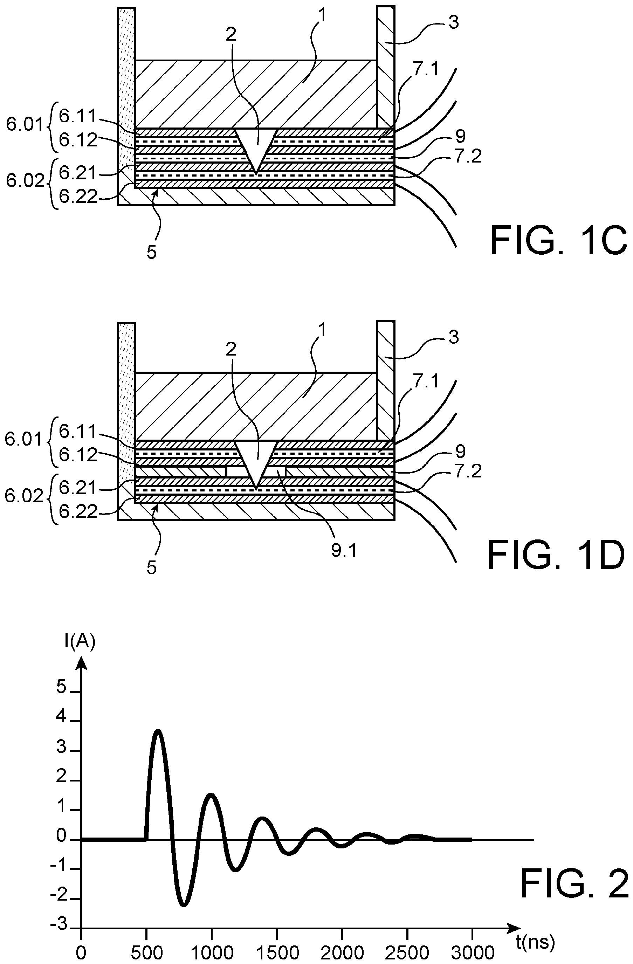

On se réfère à aux figures 1A, 1B qui montrent schématiquement un commutateur à décharge électrique (tel que présent dans le générateur d'impulsion électrique objet de l'invention), respectivement au repos en position ouverte et en cours d'activation visant à le faire passer en position fermée. On prendra également en considération la figure 1C qui montre un détail du commutateur à décharge électrique, en position fermée, une fois que la décharge a eu lieu.

Le commutateur à décharge électrique objet de l'invention comporte un piston 1 muni d'au moins un poinçon 2. En variantes décrites ultérieurement, le commutateur à décharge électrique peut comporter plusieurs pistons. Chaque piston peut être muni de plusieurs poinçons.

Ce piston 1 est apte à se déplacer dans une chambre 3 qui coopère avec un déclencheur générateur de gaz propulseur 4 destiné à mettre en mouvement le piston 1. Le commutateur à décharge électrique comporte, de plus, au moins un empilement de couches 5 formé d'au moins une paire 6 d'électrodes 6.1, 6. 2 disposées de part et d'autre d'une couche de matériau diélectrique 7. L'une des électrodes 6.1 est qualifiée d'électrode supérieure, elle est située entre la couche de matériau diélectrique 7 et le poinçon 2. L'autre électrode 6.2 est qualifiée d'électrode inférieure. Les électrodes 6.1, 6.2 de la paire d'électrodes 6 doivent être portées à des potentiels différents, au préalable, avant que le commutateur puisse être activé pour le faire passer de la position ouverte à la position fermée. Chaque paire 6 d'électrodes est associé à un poinçon 2.

Les électrodes 6.1, 6.2 sont réalisées en un matériau électriquement conducteur classiquement utilisé dans le domaine de l'électricité, tel que par exemple le cuivre, l'aluminium ou leurs alliages. Le matériau diélectrique de la couche 7 est un matériau électriquement isolant classiquement utilisé dans le domaine de l'électricité, tel que par exemple le polyéthylène, les polyimides, le kapton (marque déposée de Du Pont de Nemours). Son épaisseur est suffisante pour tenir sans claquage la tension de charge appliquée entre les électrodes 6.1, 6.2 de la paire 6.

Le poinçon 2 peut être réalisé dans un matériau électriquement isolant ou bien dans un matériau électriquement conducteur. Il doit être suffisamment dur pour pouvoir pénétrer dans le matériau diélectrique de la couche 7. Ce matériau peut être par exemple de l'acier s'il est électriquement conducteur ou par exemple le polyéthylène, le polypropylène, le polychlorure de vinyle, la céramique, une résine s'il est électriquement isolant.

Le piston 1 est placé entre le déclencheur générateur de gaz propulseur 4 et l'empilement de couches 5, le poinçon 2 se trouvant du côté de l'empilement de couches 5. Le piston 1 est disposé face à l'empilement de couches 5, la direction de son mouvement étant sensiblement perpendiculaire au plan principal des couches de l'empilement 5. Sur les figures, la chambre 3 prend appui d'un côté sur l'empilement de couches 5 et à l'opposé, est fermée par le déclencheur générateur de gaz propulseur 4. D'autres configurations sont possibles pour l'agencement entre la chambre 3, l'empilement de couches 5 et le déclencheur générateur de gaz propulseur 4.

Sur la figure 1A, le commutateur à décharge électrique est en position ouverte. Le piston 1 est en position de repos, immobile, le déclencheur générateur de gaz propulseur 4 est inactif et le poinçon 2 est à distance de l'empilement de couches 5. Un espace existe entre le déclencheur générateur de gaz propulseur 4 et le piston 1 mais ce n'est pas une obligation.

Sur la figure 1B, le commutateur à décharge électrique est en cours d'activation, le déclencheur générateur de gaz propulseur 4 a été déclenché, il produit du gaz dans la chambre 3 pour mettre en mouvement le piston 1 et celui-ci se rapproche de l'empilement de couches 5 jusqu'à venir le percuter avec suffisamment de force pour que le poinçon 2 perfore l'électrode supérieure 6.1 de la paire 6. Il rencontre en premier cette électrode 6.1 supérieure. Une fois qu'il l'a perforée, il pénètre dans la couche de matériau diélectrique 7. Le matériau diélectrique 7 est ainsi fragilisé localement par le poinçon 2. Cette fragilisation locale entraine un claquage du matériau diélectrique 7, l'apparition d'une décharge électrique entre les deux électrodes 6.1, 6.2 de la paire 6 et donc la circulation d'un courant de court-circuit entre les deux électrodes 6.1, 6.2 de la paire 6. Le courant de décharge circule dans le plasma généré par le claquage du matériau diélectrique 7. Le commutateur à décharge électrique passe en position fermée. La fermeture du commutateur à décharge électrique est extrêmement rapide par rapport à la vitesse de déplacement du piston 1. Elle est de l'ordre de quelques dizaines de nanosecondes alors que le temps mis par le poinçon 2 pour percuter l'empilement 5 est de l'ordre de quelques dizaines de microsecondes.

La figure 1C montre le piston 1 en fin de course. Sur cette figure, l'empilement de couches 5 comporte plusieurs paires 6.01, 6.02 d'électrodes empilées. Deux paires 6.01, 6.02 d'électrodes voisines sont séparées par un espaceur 9 électriquement isolant. Les électrodes 6.11, 6.12 et 6.21, 6.22 de chaque paire 6.01, 6.02 sont séparées par une couche de matériau diélectrique, respectivement 7.1 pour la première paire 6.01 et 7.2 pour la seconde paire 6.02. Le poinçon 2 a perforé les deux électrodes 6.11, 6.12 de la première paire 6.01 et la couche de matériau diélectrique 7.1 les séparant, l'espaceur 9, la première électrode 6.21 de la seconde paire 6.02 d'électrodes et a poinçonné la couche de matériau diélectrique 7.2 séparant les électrodes 6.21, 6.22 de la seconde paire 6.02.

L'espaceur 9 est réalisé en matériau électriquement isolant classiquement utilisé dans le domaine de l'électricité ou dans un matériau électriquement conducteur classiquement utilisé dans le domaine de l'électricité, dans la mesure où il possède un orifice traversant permettant au poinçon 2 électriquement conducteur de passer au travers de l'orifice sans venir en contact électrique avec lui. Ce dernier mode de réalisation est illustré sur la figure 1D. L'orifice est référencé 9.1.

Un tel empilement 5 permet d'obtenir plusieurs décharges électriques décalées dans le temps, l'une se produit lorsque le poinçon 2 percute la couche de matériau diélectrique 7.1 séparant les électrodes 6.11, 6.12 de la première paire d'électrodes 6.01 et l'autre lorsque le poinçon 2 percute la couche de matériau diélectrique 7.2 séparant les deux électrodes 6.21, 6.22 de la seconde paire d'électrodes 6.02. L'épaisseur de l'espaceur 9 contribue à ajuster l'intervalle de temps entre les deux décharges électriques.

Le déclencheur générateur de gaz propulseur 4 peut être un générateur pyrotechnique qui utilise pour générer le gaz une charge pyrotechnique. On peut utiliser un générateur pyrotechnique classique tel que ceux utilisés dans des dispositifs de sécurité et de protection comme les coussins gonflables de sécurité des automobiles. De manière connue et non représentée, la charge pyrotechnique est en contact intime avec un allumeur, cet allumeur devant être relié à un générateur basse tension. L'allumeur est une résistance chauffante ou un inflammateur de type fusible. La mise à feu du générateur de gaz pyrotechnique se fait grâce à un courant basse tension appliqué à l'allumeur, ce dernier s'échauffe par effet Joule et la chaleur est transmise par conduction thermique à la charge pyrotechnique qui est en contact avec l'allumeur. Cette mise à feu est simple à mettre en oeuvre, elle peut se faire à distance.

On pourrait, en variante, utiliser un générateur de gaz propulseur d'un autre type tel qu'un générateur de gaz hybride ou un générateur de gaz froid. Ces générateurs de gaz sont aussi classiques.

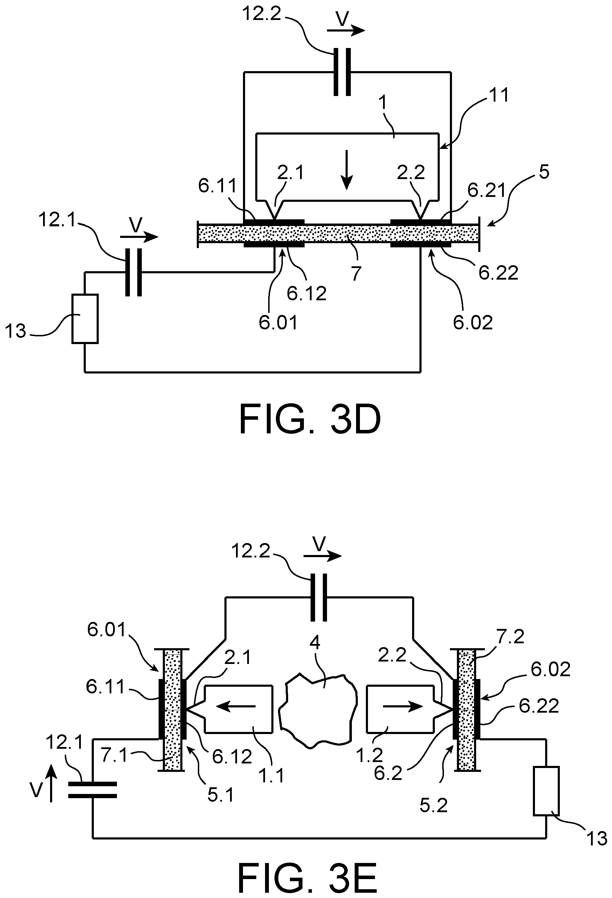

Dans un autre mode de réalisation, le piston 1 est muni de plusieurs poinçons 2.1, 2.2 pour générer plusieurs décharges électriques comme représenté sur la figure 3D. Les décharges sont sensiblement simultanées.

Pour obtenir des décharges décalées dans le temps, il est possible de prévoir plusieurs pistons munis chacun d'un poinçon comme illustré à la figure 3E décrite ultérieurement. Une telle structure pourrait également fournir des décharges simultanées.

On a représenté sur la figure 2 un chronogramme de l'amplitude du courant de décharge qui apparait lorsque le poinçon 2 entaille la couche de matériau diélectrique séparant les deux électrodes d'une paire d'électrodes. Une décharge électrique apparait dès la perforation de la couche de matériau diélectrique alors que le déclencheur générateur de gaz propulseur met plusieurs centaines de microsecondes pour se déclencher. La forme du signal représenté est lié aux caractéristiques R, L, C du circuit de décharge dans lequel les électrodes de la paire sont montées.

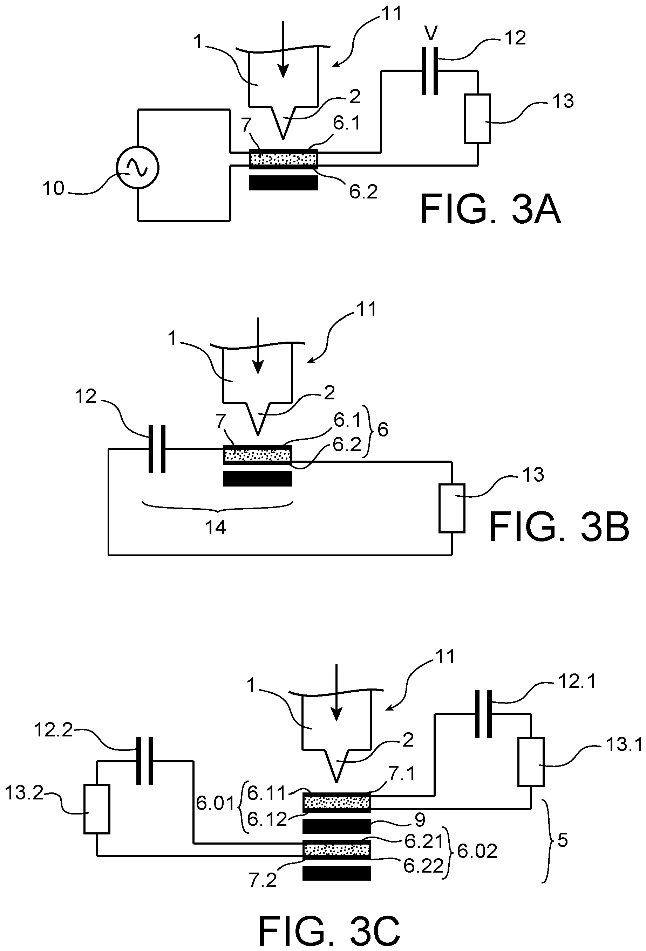

On a représenté sur les figures 3A à 3E plusieurs variantes d'un générateur d'impulsion électrique objet de l'invention.

Le générateur d'impulsion électrique est doté d'au moins un commutateur à décharge électrique 11 objet de l'invention. Le générateur d'impulsion électrique objet de l'invention comporte un commutateur à décharge électrique 11 et, de plus, au moins un dispositif de stockage d'énergie électrique 12. Le commutateur à décharge électrique 11 n'est symbolisé que par une portion d'au moins un piston 1 muni d'au moins un poinçon 2 et au moins un empilement de couches 5 muni d'au moins une paire d'électrodes 6. Chaque poinçon est associé à une paire d'électrodes.

Sur les figures 3A et 3B, l'empilement de couches 5 ne comporte qu'une paire 6 d'électrodes 6.1, 6.2 séparées par une couche de matériau diélectrique 7.

Le dispositif de stockage d'énergie électrique 12 a une de ses bornes reliée à une première électrode 6.1 de la paire d'électrodes 6, son autre borne est destinée à être reliée à première borne d'une charge 13. L'autre électrode 6.2 de la paire d'électrodes 6 est destinée à être reliée à la seconde borne de la charge 13. Le dispositif de stockage d'énergie 12 et l'empilement de couches 5, qui a une fonction de condensateur de choc, forment un ensemble série 14, la charge 13 est montée en parallèle avec l'ensemble série 14.

La charge 13 est destinée à être alimentée par une impulsion électrique fournie par le générateur d'impulsion électrique. Les deux électrodes 6.1, 6.1 d'une paire d'électrodes contribuant à former l'empilement de couches 5 du commutateur à décharge électrique 11 sont destinées à être portées, avant son déclenchement, à des potentiels différents. Le dispositif de stockage d'énergie 12 doit également être chargé avant le déclenchement du commutateur à décharge électrique 11 pour le faire passer de sa position ouverte à sa position fermée. La tension aux bornes des électrodes d'une paire d'électrodes est identique à celle existant aux bornes du dispositif de stockage d'énergie 12 avant le déclenchement du commutateur à décharge électrique 11. On a représenté sur la figure 3A avec la référence 10 une source d'alimentation électrique auxquelles sont reliées les deux électrodes 6.1, 6.2 de la paire 6. Cette source d'alimentation électrique 10 va également servir à charger au préalable le dispositif de stockage d'énergie 12. Cette source d'alimentation électrique 10 n'a pas été illustrée sur les figures 3B à 3E dans un souci de simplification.

Sur les figures 3A et 3B, le commutateur à décharge électrique 11 est pourvu d'une seule paire d'électrodes 6. Le dispositif de stockage d'énergie 12 est placé d'un côté du commutateur à décharge électrique 11 et la charge de l'autre 13. Lorsque le poinçon 2 percute la couche en matériau diélectrique 7 séparant les deux électrodes 6.1, 6.2 de la paire d'électrodes 6, le commutateur à décharge électrique se ferme laissant un courant circuler entre le dispositif de stockage d'énergie 12 et la charge 13, entraînant la décharge du dispositif de stockage d'énergie 12.

L'épaisseur de la couche de matériau diélectrique 7 séparant les deux électrodes 6.1, 6.2 de la paire d'électrodes 6 est choisie en fonction de la tension de charge V aux bornes du dispositif de stockage d'énergie 12 ou plus généralement de la capacité de stockage du dispositif de stockage d'énergie 12. Ainsi la décharge électrique générée par le commutateur à décharge électrique 11 est apte à faire se décharger le dispositif de stockage d'énergie 12.

Le dispositif de stockage d'énergie 12 peut être toute source de tension comme par exemple un condensateur, un banc de condensateurs, un super-condensateur.

Sur la figure 3C, le commutateur à décharge électrique 11 comporte un piston 1 équipé d'un seul poinçon 2 et un empilement de couches 5 formé de deux paires d'électrodes 6.01, 6.02 séparées par un espaceur 9 en matériau diélectrique. Il y a un dispositif de stockage d'énergie 12.1, 12.2 et une charge 13.1, 13.2 coopérant avec chaque paire d'électrodes 6.01, 6.02. Le montage entre chaque paire d'électrodes 6.01, 6.02, chaque dispositif de stockage d'énergie 12.1, 12.2 et chaque charge 13.1, 13.2 associés est le même que sur la figure 3A. Les claquages du matériau diélectrique sont échelonnés dans le temps puisque les deux paires d'électrodes 6.01, 6.02 sont superposées et sont séparées par l'espaceur 9. Les décharges des dispositifs de stockage d'énergie 12.1, 12.2 dans chaque charge 13.1, 13.2 sont également échelonnées dans le temps.

Sur la figure 3D, le piston 1 est équipé de deux poinçons 2.1, 2.2 en matériau électriquement isolant et l'empilement de couches 5 comporte deux paires 6.01, 6.02 d'électrodes. Chaque poinçon va coopérer 2.1, 2.2 avec l'une des paires d'électrodes 6.01, 6.02. Dans chaque paire 6.01, 6.02, les électrodes 6.11, 6.12 et 6.21, 6.22 sont séparées par une couche de matériau diélectrique 7. Les deux paires d'électrodes 6.01, 6.02 sont sans contact électrique direct.

Une seule couche de matériau diélectrique 7 peut suffire, elle est alors utilisée par les deux paires d'électrodes 6.01, 6.02. En variante deux couches de matériau diélectrique 7.1, 7.2 peuvent être prévues comme sur la figure 3E. Les deux paires d'électrodes peuvent être côte à côte comme sur la figure 3D. Les poinçons 2.1, 2.2 et les paires d'électrodes 6.01, 6.02 sont agencés les uns par rapport aux autres de manière à ce que les décharges électriques au niveau du commutateur à décharge soient sensiblement simultanées sur la figure 3D.

Sur la figure 3E, il y a plusieurs pistons 1.1, 1.2, ils sont indépendants. Chacun d'entre eux est muni d'un poinçon 2.1, 2.2. Bien entendu, ils pourraient être munis de plusieurs poinçons. Il y a autant d'empilements 5.1, 5.2 de couches distincts que de pistons. Chacun d'entre eux est dédié à un piston. Ils sont pourvus chacun d'au moins une paire d'électrodes 6.01, 6.02. Dans cet exemple simplifié, chaque poinçon 2.1, 2.2 est associé à une seule paire d'électrodes. On aurait bien sûr pu réaliser les empilements de couches ou au moins l'un d'entre eux comme illustré sur les figures 1C ou 1D. Le déclencheur générateur de gaz propulseur 4 (schématisé comme une explosion) est destiné à mettre en mouvement les deux pistons 1.1, 1.2. Les deux pistons vont avoir des sens de déplacement opposés dans ce mode de réalisation non limitatif. Leur mise en mouvement se produit de manière sensiblement simultanée lors du déclenchement du déclencheur générateur de gaz. Pour obtenir des décharges électriques successives, c'est-à-dire décalées dans le temps, il suffit que la perforation de la couche diélectrique 7.1, 7.2 de chacun des empilements 6.01, 6.02 se fasse à des instants différents. Pour cela, il suffit que les pistons 1.1, 1.2 aient des parcours de longueurs différentes avant la survenue de la perforation. Ils mettront ainsi des temps différents pour atteindre chacun la couche diélectrique qu'ils vont perforer.

Avec ce type de configuration, il est possible que les décharges électriques surviennent de manière simultanée. Pour cela, il suffit que les pistons 1.1, 1.2 aient des parcours de même longueur avant la survenue de la perforation. Ils mettront ainsi le même temps pour atteindre chacun la couche diélectrique qu'ils vont perforer.

Le générateur d'impulsion électrique, illustré sur les figures 3D ou 3E, comporte également deux dispositifs de stockage d'énergie 12.1, 12.2 connectés dans un montage série avec les paires d'électrodes 6.01, 6.02. La charge 13 est à brancher aux bornes du montage série. Le montage série est un montage alterné avec, en partant d'une borne de la charge 13, un des dispositifs de stockage d'énergie 12.1, une paire d'électrodes 6.01, le deuxième dispositif de stockage d'énergie 12.2 et la deuxième paire d'électrodes 6.02. L'autre borne de la charge 13 est connectée à la seconde électrode 6.22 de la deuxième paire d'électrodes 6.02. Dans ce contexte, la seconde électrode n'est pas percutée en premier par un poinçon.

En générant deux décharges sensiblement simultanément, la charge 13 est portée à un potentiel 2V correspondant la somme des tensions V apparaissant aux bornes de chaque dispositif de stockage d'énergie 12.1 et 12.2. On pourrait envisager que la tension aux bornes de l'un des dispositifs de stockage d'énergie soit différente de la tension aux bornes de l'autre dispositif de stockage d'énergie.

La configuration de la figure 3E permet de fonctionner avec des tensions V plus élevées que celles de la configuration de la figure 3D, car la distance entre les deux poinçons 2.1, 2.2 est plus importante, ce qui augmente l'isolation électrique lors de la charge et de la décharge.

Le commutateur à décharge électrique est insensible aux environnements sévères, il peut fonctionner sous vide, dans des environnements radiatifs. Les électrodes de l'empilement sont entièrement isolées électriquement par la couche de matériau diélectrique et il n'y a pas de risque claquage de surface. Le commutateur à décharge électrique ne risque pas non plus de commuter de manière spontanée. Il est particulièrement fiable.

Il n'a pas besoin de coopérer avec des éléments périphériques coûteux pour le faire fonctionner comme des déclencheurs haute-tension par exemple.

Le commutateur à décharge électrique est un dispositif simple, compact, monobloc. Il s'intègre facilement dans un circuit électrique. Son coût est faible grâce à ses composants, des pièces mécaniques simples comme le piston, l'empilement avec une ou plusieurs paires d'électrodes et une ou plusieurs couches en matériau diélectrique, un déclencheur générateur de gaz propulseur du conventionnel.

Il peut être aisément adapté au dispositif de stockage d'énergie avec qui il va coopérer en ajustant l'épaisseur de la couche de matériau diélectrique entre les deux électrodes d'une paire, la géométrie de l'empilement ou de chaque empilement, le nombre de paires d'électrodes, de pistons, de poinçons.

Il est insensible au courant de décharge lorsqu'il est utilisé dans un générateur d'impulsion électrique avec au moins un dispositif de stockage d'énergie.

Selon la configuration du commutateur à décharge électrique, il peut être facilement réutilisable après remplacement de l'empilement de couches et du déclencheur générateur de gaz propulseur. Ce dernier peut être mono coup ou multi coups.

## Revendications

1. Générateur d'impulsion électrique, qui comporte un commutateur à décharge électrique, le commutateur à décharge électrique comportant au moins un piston (1) et une chambre (3) dans laquelle le ou chaque piston (1) est apte à se déplacer, un déclencheur générateur de gaz propulseur (4) pour mettre en mouvement le ou chaque piston (1) situé à proximité d'une extrémité du ou de chaque piston (1), au moins un poinçon (2) solidaire de l'autre extrémité du ou de chaque piston (1), au moins un empilement de couches (5) formé d'au moins une paire d'électrodes (6) séparées par une couche de matériau diélectrique (7), le ou chaque empilement (5) étant situé du côté d'un ou de plusieurs poinçons (2), le ou chaque poinçon étant destiné à coopérer avec au moins une paire d'électrodes, les électrodes (6.1, 6.2) de ladite paire étant destinées à être portées à des potentiels différents avant la mise en mouvement du piston (1) portant le poinçon destiné à coopérer avec ladite paire d'électrodes, de manière à ce que lorsque ledit piston (1) est mis en vitesse par le gaz généré par le déclencheur générateur de gaz propulseur (4), il poinçonne la couche de matériau diélectrique (7) séparant les électrodes de ladite paire, entraînant le claquage du matériau diélectrique et la survenue d'une décharge électrique entre les électrodes (6.1, 6.2) de ladite paire,
le générateur d'impulsion électrique étant destiné à alimenter une charge, le générateur d'impulsion électrique comportant, en outre, un dispositif de stockage d'énergie (12.1, 12.2) associé avec la ou chaque paire d'électrodes (6.01, 6.02) du commutateur à décharge électrique en au moins un montage en série, la charge (13) ou chaque charge étant destinée à être montée en parallèle avec le ou chaque montage en série.

2. Générateur d'impulsion électrique selon la revendication 1, dans lequel le ou chaque empilement de couches (5) comporte plusieurs paires d'électrodes (6.01, 6.02) empilées, séparées chacune par une couche de matériau diélectrique (7.1, 7.2), deux paires voisines (6.01, 6.02) étant séparées par un espaceur (9) électriquement isolant, de manière à ce que le poinçon (2) destiné à coopérer avec lesdites paires d'électrodes en poinçonnant les couches de matériau diélectrique (7.1, 7.2) entraîne la génération de plusieurs décharges électriques séparées dans le temps.

3. Générateur d'impulsion électrique selon la revendication 2, dans lequel l'épaisseur de l'espaceur (9) entre deux paires d'électrodes (6.01, 6.02) voisines conditionne l'intervalle de temps entre deux décharges électriques successives.

4. Générateur d'impulsion électrique selon l'une des revendications 1 à 3, dans lequel un piston au moins (1) est équipé de plusieurs poinçons (2.1, 2.2), un même empilement comportant au moins autant de paires d'électrodes (6.01, 6.02) que le nombre de poinçons (2.1, 2.2) dudit piston (1), ces paires d'électrodes étant séparées par une couche de matériau diélectrique (7, 7.1, 7.2), les électrodes de paires différentes étant sans contact électrique direct.

5. Générateur d'impulsion électrique selon la revendication 4, dans lequel la couche de matériau diélectrique (7) est commune à plusieurs paires d'électrodes (6.01, 6.02).

6. Générateur d'impulsion électrique selon l'une des revendications 4 ou 5, dans lequel les poinçons (2.1, 2.2) dudit piston (1) en poinçonnant chacun la couche de matériau diélectrique (7, 7.1, 7.2) séparant deux électrodes (6.11, 6.12) d'une paire d'électrodes (6.01) déclenchent des décharges électriques sensiblement simultanées.

7. Générateur d'impulsion électrique selon l'une des revendications précédentes, dans lequel le commutateur à décharge électrique comporte plusieurs pistons (1.1, 1.2), chacun équipé d'au moins un poinçon (2.1, 2.2) et un empilement de couches (5.1, 5.2) dédié à chacun des pistons, chaque empilement de couches (5.1, 5.2) comportant au moins une paire (6.01, 6.02) d'électrodes (6.11, 6.12 ; 6.21, 6.22) par poinçon (2.1, 2.2) du piston dédié (1.1, 1.2), ces électrodes (6.11, 6.12 ; 6.21, 6.22) étant séparées par une couche de matériau diélectrique (7.1, 7.2), dans lequel les poinçons (2.1, 2.2) en perforant chacun une couche en matériau diélectrique (7.1, 7.2) déclenchent des décharges électriques sensiblement simultanées ou successives.

8. Générateur d'impulsion électrique selon l'une des revendications 1 à 7, dans lequel le déclencheur de gaz propulseur (4) est une cartouche pyrotechnique génératrice de gaz.

9. Générateur d'impulsion électrique selon l'une des revendications 1 à 8, dans lequel le ou chaque poinçon (2) est réalisé en matériau électriquement isolant de préférence choisi parmi le polyéthylène, le polypropylène, le polychlorure de vinyle, la céramique, une résine ou dans un matériau électriquement conducteur, de préférence en acier.

10. Générateur d'impulsion électrique selon l'une des revendications 1 à 9, dans lequel le matériau diélectrique de la couche (7) est de préférence choisi parmi le polyéthylène, les polyimides, le kapton.

11. Générateur d'impulsion électrique selon l'une des revendications 2 ou 3, dans lequel l'espaceur (9) est réalisé dans un matériau électriquement isolant ou dans un matériau électriquement conducteur, l'espaceur (9) en matériau électriquement conducteur étant muni d'au moins un orifice (9.1) dimensionné de manière à pouvoir être traversé par un poinçon, et à être sans contact électrique avec le poinçon qui le traverse, lorsque le poinçon (2) est en matériau électriquement conducteur.

12. Générateur d'impulsion électrique selon l'une des revendications 1 à 11, dans lequel les électrodes (6.11, 6.12) de la paire ou de chaque paire sont réalisées dans un matériau électriquement conducteur de préférence choisi parmi l'aluminium, le cuivre, leurs alliages.

13. Générateur d'impulsion électrique selon l'une quelconque des revendications 1 à 12, dans lequel l'épaisseur de la couche de matériau diélectrique (7) séparant la ou chaque paire d'électrodes est choisie en fonction de la capacité de stockage du dispositif de stockage d'énergie (12) associé avec la ou chaque paire d'électrodes afin que la décharge électrique générée par le commutateur à décharge électrique (11) soit apte à faire se décharger le dispositif de stockage d'énergie (12).

14. Générateur d'impulsion électrique selon l'une quelconque des revendications 1 à 13, dans lequel le dispositif de stockage d'énergie (12) est une source de tension, de préférence, choisie parmi un condensateur, un banc de condensateurs, un super-condensateur.

## Patentansprüche

1. Elektrischer Impulsgenerator, umfassend:
einen elektrischen Entladeschalter, wobei der elektrische Entladeschalter wenigstens einen Kolben (1) und eine Kammer (3) umfasst, in welcher der oder jeder Kolben (1) in der Lage ist, sich zu verlagern, einen Treibgas-Erzeugerauslöser (4), um den oder jeden Kolben (1) in Bewegung zu setzen, angeordnet in der Nähe eines Endes des oder jeden Kolbens (1), wenigstens einen Stichel (2), welcher mit dem anderen Ende des oder jeden Kolbens (1) verbunden ist, wenigstens einen Stapel von Schichten (5), welcher aus wenigstens einem Paar von Elektroden (6) gebildet ist, welche durch eine Schicht aus dielektrischem Material (7) getrennt sind, wobei der oder jeder Stapel (5) an einer Seite von einem oder mehreren Sticheln (2) angeordnet ist, wobei der oder jeder Stichel dazu vorgesehen ist, mit wenigstens einem Paar von Elektroden zusammenzuwirken, wobei die Elektroden (6.1, 6.2) des Paars dazu vorgesehen sind, auf unterschiedliche Potentiale gelegt zu werden, bevor der Kolben (1), welcher den Stichel trägt, welcher dazu vorgesehen ist, mit dem Paar von Elektroden zusammenzuwirken, in Bewegung versetzt wird, so dass während der Kolben (1) durch das durch den Treibgas-Erzeugerauslöser (4) erzeugte Gas beschleunigt wird, er die Schicht aus dielektrischem Material (7) durchsticht, wodurch die Elektroden des Paars getrennt werden, wodurch ein Durchschlag des dielektrischen Materials und das Auftreten einer elektrischen Entladung zwischen den Elektroden (6.1, 6.2) des Paars ausgelöst wird, wobei der elektrische Impulsgenerator dazu vorgesehen ist, eine Last zu versorgen, wobei der elektrische Impulsgenerator ferner eine Energiespeicher-Vorrichtung (12.1, 12.2) umfasst, welche dem oder jedem Paar von Elektroden (6.01, 6.02) des elektrischen Entladeschalters in wenigstens einer Reihenschaltung zugeordnet ist, wobei die Last (13) oder jede Last dazu vorgesehen ist, parallel zu der oder jeder Reihenschaltung geschaltet zu sein.

2. Elektrischer Impulsgenerator nach Anspruch 1, wobei der oder jeder Stapel von Schichten (5) mehrere Paare von gestapelten Elektroden (6.01, 6.02) umfasst, welche jeweils durch eine Schicht aus dielektrischem Material (7.1, 7.2) getrennt sind, wobei zwei benachbarte Paare (6.01, 6.02) durch ein elektrisch isolierendes Abstandselement (9) derart getrennt sind, dass der Stichel (2), welcher dazu vorgesehen ist, mit den Paaren von Elektroden durch Durchstechen der Schichten aus dielektrischem Material (7.1, 7.2) zusammenzuwirken, die Erzeugung von mehreren elektrischen Entladungen auslöst, welche zeitlich getrennt sind.

3. Elektrischer Impulsgenerator nach Anspruch 2, wobei die Dicke des Abstandselements (9) zwischen zwei benachbarten Paaren von Elektroden (6.01, 6.02) das Zeitintervall zwischen zwei aufeinander folgenden elektrischen Entladungen bewirkt.

4. Elektrischer Impulsgenerator nach einem der Ansprüche 1 bis 3, wobei wenigstens ein Kolben (1) mit mehreren Sticheln (2.1, 2.2) ausgerüstet ist, wobei ein einzelner Stapel wenigstens gleich viele Paare von Elektroden (6.01, 6.02) umfasst wie die Anzahl von Sticheln (2.1, 2.2) des Kolbens (1), wobei die Paare von Elektroden durch eine Schicht aus dielektrischem Material (7, 7.1, 7.2) getrennt sind, wobei die Elektroden von verschiedenen Paaren ohne direkten elektrischen Kontakt sind.

5. Elektrischer Impulsgenerator nach Anspruch 4, wobei die Schicht aus dielektrischem Material (7) mehreren Paaren von Elektroden (6.01, 6.02) gemein ist.

6. Elektrischer Impulsgenerator nach einem der Ansprüche 4 oder 5, wobei die Stichel (2.1, 2.2) des Kolbens (1) beim jeweiligen Durchstechen der Schicht aus dielektrischem Material (7, 7.1, 7.2) zwei Elektroden eines Paars von Elektroden (6.11, 6.12) trennen, wobei im Wesentlichen gleichzeitige elektrische Entladungen ausgelöst werden.

7. Elektrischer Impulsgenerator nach einem der vorhergehenden Ansprüche, wobei der elektrische Entladeschalter mehrere Kolben (1.1, 1.2) umfasst, welche jeweils mit wenigstens einem Stichel (2.1, 2.2) und einem Stapel von Schichten (5.1, 5.2) ausgerüstet sind, welcher jedem der Kolben zugewiesen ist, wobei jeder Stapel von Schichten (5.1, 5.2) wenigstens ein Paar (6.01, 6.02) von Elektroden (6.11, 6.12; 6.21, 6.22) pro Stichel (2.1, 2.2) des zugewiesenen Kolbens (1.1, 1.2) umfasst, wobei die Elektroden (6.11, 6.12; 6.21, 6.22) durch eine Schicht aus dielektrischem Material (7.1, 7.2) getrennt sind, wobei die Stichel (2.1, 2.2) beim jeweiligen Durchstechen einer Schicht aus dielektrischem Material (7.1, 7.2) im Wesentlichen gleichzeitige oder aufeinander folgende elektrische Entladungen auslösen.

8. Elektrischer Impulsgenerator nach einem der Ansprüche 1 bis 7, wobei der Treibgas-Erzeugerauslöser (4) eine pyrotechnische Gaserzeugungs-Kartusche ist.

9. Elektrischer Impulsgenerator nach einem der Ansprüche 1 bis 8, wobei der oder jeder Stichel (2) aus elektrisch isolierendem Material hergestellt ist, welches vorzugsweise ausgewählt ist aus Polyethylen, Polypropylen, Polyvinylchlorid, Keramik, einem Harz, oder aus einem elektrisch leitfähigen Material, vorzugsweise Stahl.

10. Elektrischer Impulsgenerator nach einem der Ansprüche 1 bis 9, wobei das dielektrische Material der Schicht (7) vorzugsweise ausgewählt ist aus Polyethylen, Polyimiden, Kapton.

11. Elektrischer Impulsgenerator nach einem der Ansprüche 2 oder 3, wobei das Abstandselement (9) aus einem elektrisch isolierenden Material oder aus einem elektrisch leitfähigen Material hergestellt ist, wobei das Abstandselement (9) aus elektrisch leitfähigem Material mit wenigstens einer Öffnung (9.1) versehen ist, welche derart bemessen ist, dass sie von einem Stichel durchquert werden kann, und ohne elektrischen Kontakt mit dem sie durchquerenden Stichel, wenn der Stichel (2) aus elektrisch leitfähigem Material hergestellt ist.

12. Elektrischer Impulsgenerator nach einem der Ansprüche 1 bis 11, wobei die Elektroden (6.11, 6.12) des Paars oder jedes Paars aus einem elektrisch leitfähigen Material hergestellt sind, vorzugsweise ausgewählt aus Aluminium, Kupfer, ihren Legierungen.

13. Elektrischer Impulsgenerator nach einem der Ansprüche 1 bis 12, wobei die Dicke der Schicht aus dielektrischem Material (7), welche das oder jedes Paar von Elektroden trennt, ausgewählt ist als Funktion der Speicherkapazität der Energiespeicher-Vorrichtung (12), welche dem oder jedem Paar von Elektroden zugeordnet ist, so dass die von dem elektrischen Entladeschalter (11) erzeugte elektrische Entladung in der Lage ist, die Energiespeicher-Vorrichtung (12) dazu zu bringen, sich zu entladen.

14. Elektrischer Impulsgenerator nach einem der Ansprüche 1 bis 13, wobei die Energiespeicher-Vorrichtung (12) eine Spannungsquelle ist, vorzugsweise ausgewählt aus einem Kondensator, einer Bank aus Kondensatoren, einem Superkondensator.

## Claims

1. An electric pulse generator, including an electric discharge switch, the electric discharge switch including at least one piston (1) and a chamber (3) in which the or each piston (1) is capable of moving, a propellant gas-generating trigger (4) for moving the or each piston (1) located in proximity to an end of the or each piston (1), at least one punch (2) rigidly connected to the other end of the or each piston (1), at least one stack of layers (5) formed from at least one pair of electrodes (6) separated by a layer of dielectric material (7), the or each stack (5) being located on the side of one or more punches (2), the or each punch being intended to cooperate with at least one pair of electrodes, the electrodes (6.1, 6.2) of said pair being intending to be brought to different potentials before moving the piston (1) carrying the punch intended to cooperate with said pair of electrodes, so that when said piston (1) is speeded up by the gas generated by the propellant gas-generated trigger (4), it punches the layer of dielectric material (7) separating the electrodes of said pair, leading to the breakdown of the dielectric material and the occurrence of an electric discharge between the electrodes (6.1, 6.2) of said pair,
the electric pulse generator being intended to power a load, the electric pulse generator further including an energy storage device (12.1, 12.2) associated with the or each pair of electrodes (6.01, 6.02) of the electric discharge switch in at least one series connection, the load (13) or each load being intended to be connected in parallel with the or each series connection.

2. The electric pulse generator according to claim 1, wherein the or each stack of layers (5) includes several stacked pairs of electrodes (6.01, 6.02), each separated by a layer of dielectric material (7.1, 7.2), two neighbouring pairs (6.01, 6.02) being separated by an electrically insulating spacer (9), so that the punch (2) intended to cooperate with said pairs of electrodes by punching the layers of dielectric material (7.1, 7.2) leads to the generation of several electric discharges separated in time.

3. The electric pulse generator according to claim 2, wherein the thickness of the spacer (9) between two neighbouring pairs of electrodes (6.01, 6.02) conditions the time interval between two successive electric discharges.

4. The electric pulse generator according to one of claims 1 to 3, wherein at least one piston (1) is fitted with several punches (2.1, 2.2), a same stack including at least as many pairs of electrodes (6.01, 6.02) as the number of punches (2.1, 2.2) of said piston (1), these pairs of electrodes being separated by a layer of dielectric material (7, 7.1, 7.2), the electrodes of different pairs being without a direct electric contact.

5. The electric pulse generator according to claim 4, wherein the layer of dielectric material (7) is common to several pairs of electrodes (6.01, 6.02).

6. The electric pulse generator according to one of claims 4 or 5, wherein the punches (2.1, 2.2) of said piston (1) by each punching the layer of dielectric material (7, 7.1, 7.2) separating two electrodes (6.11, 6.12) of a pair of electrodes (6.01) trigger substantially simultaneous electric discharges.

7. The electric pulse generator according to one of the preceding claims, wherein the electric discharge switch includes several pistons (1.1, 1.2), each fitted with at least one punch (2.1, 2.2) and a stack of layers (5.1, 5.2) dedicated to each piston, each stack of layers (5.1, 5.2) including at least one pair (6.01, 6.02) of electrodes (6.11, 6.12; 6.21, 6.22) per punch (2.1, 2.2) of the dedicated piston (1.1, 1.2), these electrodes (6.11, 6.12; 6.21, 6.22) being separated by a layer of dielectric material (7.1, 7.2), wherein the punches (2.1, 2.2) by each perforating a layer of dielectric material (7.1, 7.2) trigger substantially simultaneous or successive electric discharges.

8. The electric pulse generator according to one of claims 1 to 7, wherein the propellant gas trigger (4) is a gas generating-pyrotechnic cartridge.

9. The electric pulse generator according to one of claims 1 to 8, wherein the or each punch (2) is made of an electrically insulating material preferably selected from polyethylene, polypropylene, polyvinyl chloride, ceramics, a resin or of an electrically conducting material, preferably of steel.

10. The electric pulse generator according to one of claims 1 to 9, wherein the dielectric material of the layer (7) is preferably selected from polyethylene, polyimides, kapton.

11. The electric pulse generator according to one of claims 2 or 3, wherein the spacer (9) is made of an electrically insulating material or of an electrically conducting material, the spacer (9) of an electrically conducting material being provided with at least one hole (9.1) sized so as to be able to be passed through by a punch, and to be without an electric contact with the punch passing through it, when the punch (2) is made of an electrically conducting material.

12. The electric pulse generator according to one of claims 1 to 11, wherein the electrodes (6.11, 6.12) of the pair or of each pair are made of an electrically conducting material preferably selected from aluminium, copper, the alloys thereof.

13. The electric pulse generator according to any of claims 1 to 12, wherein the thickness of the layer of dielectric material (7) separating the or each pair of electrodes is selected as a function of the storage capacity of the energy storage device (12) associated with the or each pair of electrodes so that the electric discharge generated by the electric discharge switch (11) is capable of making the energy storage device discharge (12) itself.

14. The electric pulse generator according to any of claims 1 to 13, wherein the energy storage device (12) is a voltage source, preferably selected from a capacitor, a capacitor bank, a supercapacitor.
